(19) **Europäisches Patentamt / European Patent Office / Office européen des brevets**

(11) **EP 4 715 096 A1**

(12) **EUROPEAN PATENT APPLICATION**
published in accordance with Art. 153(4) EPC

(43) Date of publication:
25.03.2026 Bulletin 2026/13

(21) Application number: 24825124.1

(22) Date of filing: 29.05.2024

(51) International Patent Classification (IPC):
*C30B 23/02* $^{(2006.01)}$

(52) Cooperative Patent Classification (CPC):
C30B 23/00; C30B 23/02; C30B 29/36;
G01N 21/59; G01N 21/65

(86) International application number:
PCT/CN2024/096122

(87) International publication number:
WO 2024/260228 (26.12.2024 Gazette 2024/52)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 21.06.2023 CN 202310746123

(71) Applicant: SICC (Shanghai) Semiconductor
Materials Co., Ltd.
Shanghai 201306 (CN)

(72) Inventors:
• SHU, Tianyu
Shanghai 201306 (CN)
• SHI, Zhiqiang
Shanghai 201306 (CN)

• WANG, Qi
Shanghai 201306 (CN)
• SONG, Meng
Shanghai 201306 (CN)
• WANG, Kai
Shanghai 201306 (CN)
• ZHANG, Lin
Shanghai 201306 (CN)
• PENG, Hongyu
Shanghai 201306 (CN)
• LI, Lin
Shanghai 201306 (CN)
• XU, Guangming
Shanghai 201306 (CN)

(74) Representative: Huang, Liwei
Cäcilienstraße 12
40597 Düsseldorf (DE)

(54) **SIC SUBSTRATE HAVING UNIFORM STRESS DISTRIBUTION IN THREE-DIMENSIONAL DIRECTION, AND SIC CRYSTAL**

(57) The present application belongs to the technical field of SiC production and processing. Disclosed are an SiC substrate having uniform stress distribution in a three-dimensional direction, and an SiC crystal. The SiC substrate comprises a first surface layer, a second surface layer and an intermediate layer, wherein on the same axis, at any plane parallel to a first main surface or a second main surface in the first surface layer, $Smax_1$ represents the maximum value of an absolute value of a radial stress in the first surface layer, $Smax_2$ represents the maximum value of an absolute value of a radial stress in the intermediate layer, $Smax_3$ represents the maxi-

mum value of an absolute value of a radial stress in the second surface layer. $\Delta S1 = Smax_2 - Smax_1$, $\Delta S2 = Smax_2 - Smax_3$, $-15\ MPa \leq \Delta S1 \leq 10\ MPa$, and $-15\ MPa \leq \Delta S2 \leq 10\ MPa$. The radial stresses in the SiC substrate in all of the first surface layer, the second surface layer and the intermediate layer are relatively low, the stress distribution uniformity among the layers is good, so that the quality of the SiC substrate can be improved, the usage range of the SiC substrate is expanded, and the production and processing of downstream epitaxial wafers and crystals are facilitated.

EP 4 715 096 A1

FIG. 5

**Description**

CROSS-REFERENCE TO RELATED APPLICATIONS

The present application claims the benefit of priority of Chinese Patent Application No. 202310746123.9, filed with the China National Intellectual Property Administration on June 21, 2023, and titled "SIC SUBSTRATE AND SIC CRYSTAL THAT FEATURE UNIFORM DISTRIBUTION OF STRESSES IN THREE DIMENSIONS", the entire content of which is incorporated herein by reference.

TECHNICAL FIELD

The present application relates to the field of silicon carbide (SiC) production and processing technologies, and in particular to an SiC substrate and an SiC crystal that feature a uniform distribution of stresses in three dimensions.

BACKGROUND

During the growth of SiC crystals, defects such as polycrystalline, polymorphism, micropipes, and dislocations are easily introduced into the crystals due to factors such as Si/C ratio imbalance, introduction of impurities, and temperature gradient changes. These defects will cause lattice distortion, or more seriously, crystal transformation, such as intergrowth of multiple crystal forms including 4H, 6H, 3C, and 15R. Lattice distortion will release stress by the generated defects, that is to say, introducing internal stress into SiC crystals, thereby reducing the quality of SiC crystals, limiting their use range, affecting their subsequent processing, and bringing down the yield rate.

On the other hand, SiC substrates are generally obtained by cutting from crystal boules with machining methods, such as laser cutting and wire cutting, and then subject to surface treatment through machining technologies such as grinding and polishing. During the processing of a substrate, the mechanical stress will cause microcracks on the surface and introduce a damage layer. For SiC substrate, the thickness difference of damage layer between the C and Si surfaces will affect the surface quality of the substrate, thereby affecting the production and processing of downstream products. Therefore, there are both internal and surface stresses of the SiC substrate. When the SiC substrate is used for crystal growth or epitaxial layer growth, the stresses of the SiC substrate will be passed to the crystal or epitaxial layer, resulting in more defects in the epitaxial layer and crystal, which increases the opportunity of cracking and uneven quality, making it difficult to carry out subsequent processing and production.

SUMMARY

In order to solve the above-mentioned problems, the present application provides an SiC substrate and an SiC crystal that feature a uniform distribution of stresses in three dimensions. The SiC substrate includes a first surface layer, a second surface layer, and an intermediate layer. The radial stresses of the SiC substrate in the three layers are relatively low, with good stress distribution uniformity among the layers, which can improve the quality of the SiC substrate, expand its use range, and facilitate the production and processing of downstream products. When used for crystal or epitaxial layer growth, the SiC substrate can improve the quality of crystals and the epitaxial layer.

According to one aspect of the present application, an SiC substrate featuring a uniform distribution of stresses in three dimensions is provided; the SiC substrate has a thickness of not less than 100 $\mu$m and includes a first main surface and a second main surface; a 10 nm to 30 $\mu$m thick area from the first main surface oriented toward the second main surface is a first surface layer, a 10 nm to 30 $\mu$m thick area from the second main surface oriented toward the first main surface is a second surface layer, and an area between the first surface layer and the second surface layer is an intermediate layer;

on a same axis, at any plane parallel to the first or the second main surface, $Smax_1$ represents the maximum absolute value of a radial stress in the first surface layer, $Smax_2$ represents the maximum absolute value of a radial stress in the intermediate layer, and $Smax_3$ represents the maximum absolute value of a radial stress in the second surface layer, in which $\Delta S1 = Smax_2 - Smax_1$, $\Delta S2 = Smax_2 - Smax_3$, $-15 \text{ MPa} \leq \Delta S1 \leq 10 \text{ MPa}$, and $-15 \text{ MPa} \leq \Delta S2 \leq 10 \text{ MPa}$; and optionally, $-14.9 \text{ MPa} \leq \Delta S1 \leq 7.7 \text{ MPa}$ and $-14.6 \text{ MPa} \leq \Delta S2 \leq 7.9 \text{ MPa}$.

In the description above, $\Delta S1$ represents the radial stress difference between the first surface layer and the intermediate layer, and $\Delta S2$ represents the radial stress difference between the second surface layer and the intermediate layer. The closer to 0 the $\Delta S1$ value is, the more uniform the radial stress distribution between the first surface layer and the intermediate layer is, and the better the quality of the substrate is. The closer to 0 the $\Delta S2$ value is, the more uniform the radial stress distribution between the second surface layer and the intermediate layer is, and the better the quality of the substrate is. If both ΔS1 and ΔS2 are close to 0, the radial stress distribution of the substrate is uniform in the axial direction, and the quality of the substrate is optimal.

Optionally, at any plane which is located in the first surface layer and is parallel to the first main surface, the radial stress of the SiC substrate is -15 MPa to 15 MPa; at any plane which is located in the second surface layer and is parallel to the second main surface, the radial stress of the SiC substrate is -15 MPa to 15 MPa; and

at any plane which is located in in the intermediate layer and is parallel to the first main surface or the second main surface, the radial stress of the SiC substrate is -10 MPa to 10 MPa.

The tensile or compressive stress in the SiC substrate will cause expansion or contraction of the interplanar spacing d correspondingly, and the Raman peak will shift toward low frequency or high frequency accordingly when Raman spectroscopy is used for stress testing. When the substrate is subjected to the tensile stress inside, the Raman peak shifts toward low frequency, and the obtained stress value is positive. When the substrate is subjected to the compressive stress inside, the Raman peak shifts toward high frequency, and the obtained stress value is negative. Therefore, the positive and negative signs before the stress value in the present application represent the force direction inside the substrate, and the absolute value represents the magnitude of stress. For example, when the radial stress of the SiC substrate in the first surface layer is -15 MPa and the radial stress in the second surface layer is -10 MPa, both the radial stresses in the first surface layer and the second surface layer are compressive stresses, and the radial pressure on the first surface layer is greater than the radial pressure on the second surface layer.

The radial stresses in the first surface layer and the second surface layer are the surface stresses of the substrate. The thicknesses of the first surface layer and the second surface layer vary with the substrate processing technologies such as cutting, grinding, and polishing. The thinner the first surface layer and the second surface layer are, the smaller the radial stresses in the first surface layer and the second surface layer are. A 10 nm to 30 μm thick area from the first main surface oriented toward the second main surface is a first surface layer. The closer to 10 nm the value of the above area is, the smaller the radial stress of the SiC substrate in the first surface layer is, that is to say, closer to 0 MPa. The closer to 30 μm the value of the above area is, the greater the radial stress of the SiC substrate in the first surface layer is, that is to say, closer to -15 MPa or 15 MPa. Similarly, a 10 nm to 30 μm thick area from the second main surface oriented toward the first main surface is a second surface layer. The closer to 10 nm the value of the above area is, the smaller the radial stress of the SiC substrate in the second surface layer is, that is to say, closer to 0 MPa. The closer to 30 μm the value of the above area is, the greater the radial stress of the SiC substrate in the second surface layer is, that is to say, closer to -15 MPa or 15 MPa.

Optionally, -5 MPa ≤ $Smax_3$ - $Smax_1$ ≤ 5 MPa.

Optionally, -4.9 MPa ≤ $Smax_3$ - $Smax_1$ ≤ 5 MPa. $Smax_3$ - $Smax_1$ represents the radial stress difference between the first surface layer and the second surface layer. The smaller its value is, the more uniform the radial stress distribution between the first surface layer and the second surface layer of the substrate is.

Optionally, the diameter of the SiC substrate is 150 mm or greater.

Optionally, the diameter of the SiC substrate is 200 mm or greater.

Optionally, the radial stress includes an absolute radial stress and a relative radial stress; and

at any plane which is located in the first surface layer and is parallel to the first main surface, the absolute radial stress of the SiC substrate is -15 MPa to 15 MPa, and the relative radial stress of the SiC substrate is -15 MPa to 14.5 MPa.

Optionally, the relative radial stress of the SiC substrate is -14.9 MPa to 14.5 MPa; and

at any plane which is located in the second surface layer and is parallel to the second main surface, the absolute radial stress of the SiC substrate is -15 MPa to 15 MPa, and the relative radial stress of the SiC substrate is -15 MPa to 14.5 MPa.

Optionally, the relative radial stress of the SiC substrate is -14.7 MPa to 14.5 MPa; and

at any plane which is located in in the intermediate layer and is parallel to the first main surface or the second main surface, the absolute radial stress of the SiC substrate is -10 MPa to 10 MPa, and the relative radial stress of the SiC substrate is -8 MPa to 8 MPa.

Absolute stresses can reflect the difference between the substrate and a perfect SiC crystal with no defect, and are used to determine the stress level of the SiC substrate. However, since it is difficult to achieve a perfect SiC substrate with no defect in the prior art, the relative stress distribution in the substrate surface can be determined in terms of relative stresses.

For example, when the absolute stress of the substrate is large and the relative stress is small, there are a lot of in-plane defects, but the stress distribution is uniform, the crystal quality is poor, and the uniformity quality in every area of the substrate is poor; or when the absolute stress is small and the relative stress is large, the overall substrate quality is good, but there are abnormal quality deviations locally.

The reference value of absolute stress in the present application is the reference stress calculated at the standard Raman peak position obtained based on perfect SiC lattice parameters, denoted as 0. The relative stress of a testing point is calculated with a numerical method based on the value of stress at the testing point and a reference value on the entire test plane. The reference value can be selected from the group including but not limited to the average, median, and modal number of all the stress values across the entire test plane, as well as the results calculated by using other statistical functions.

Optionally, on a same axis, at any plane parallel to the first main surface or the second main surface, $Smin_1$ represents the minimum absolute value of radial stress in the first surface layer, $Smin_2$ represents the minimum absolute value of radial stress in the intermediate layer, and $Smin_3$ represents the minimum absolute value of radial stress in the second surface layer, in which $\Delta S3 = Smin_2 - Smin_1$, $\Delta S4 = Smin_2 - Smin_3$, $-5$ MPa $\leq \Delta S3 \leq 5$ MPa, and $-5$ MPa $\leq \Delta S4 \leq 5$ MPa; and

optionally, $-5$ MPa $\leq Smin_3 - Smin_1 \leq 5$ MPa.

Optionally, $-4.8$ MPa $\leq \Delta S3 \leq 5$ MPa, $-5$ MPa $\leq \Delta S4 \leq 4.8$ MPa, and $-4.5$ MPa $\leq Smin_3 - Smin_1 \leq 4.4$ MPa.

Optionally, based on an axial test by extending from any point on the first main surface toward the inside of the SiC substrate along the perpendicular direction, the axial stress of the SiC substrate in the first surface layer is $-10$ MPa to 10 MPa, the axial stress of the SiC substrate in the intermediate layer is $-10$ MPa to 10 MPa, and the axial stress of the SiC substrate in the second surface layer is $-10$ MPa to 10 MPa.

Optionally, the axial stress includes an absolute axial stress and a relative axial stress, and the axial test is performed by extending from any point on the first main surface toward the inside of the SiC substrate along the perpendicular direction; and

the absolute axial stress of the SiC substrate in the first surface layer is $-10$ MPa to 10 MPa, and the relative axial stress of the SiC substrate in the first surface layer is $-8$ MPa to 8 MPa.

Optionally, the relative axial stress of the SiC substrate in the first surface layer is $-7.8$ MPa to 7.9 MPa.

The absolute axial stress of the SiC substrate in the intermediate layer is $-10$ MPa to 10 MPa, and the relative axial stress of the SiC substrate in the intermediate layer is $-8$ MPa to 8 MPa.

Optionally, the relative axial stress of the SiC substrate in the intermediate layer is $-8.0$ MPa to 7.8 MPa.

The absolute axial stress of the SiC substrate in the second surface layer is $-10$ MPa to 10 MPa, and the relative axial stress of the SiC substrate in the second surface layer is $-8$ MPa to 8 MPa.

Optionally, the relative axial stress of the SiC substrate is $-7.8$ MPa to 8.0 MPa.

Optionally, based on an axial test by extending from any point on the first main surface toward the inside of the SiC substrate along the perpendicular direction, S1 represents the maximum axial stress in the first surface layer and S2 represents the minimum axial stress in the first surface layer, in which $\Delta S5 = S1 - S2$, and 0 MPa $\leq \Delta S5 \leq 15$ MPa;

S3 represents the maximum axial stress in the intermediate layer and S4 represents the minimum axial stress in the intermediate layer, in which $\Delta S6 = S3 - S4$, and 0 MPa $\leq \Delta S6 \leq 10$ MPa; and

S5 represents the maximum axial stress in the second surface layer and S6 represents the minimum axial stress in the second surface layer, in which $\Delta S7 = S5 - S6$, and 0 MPa $\leq \Delta S7 \leq 15$ MPa.

The maximum and minimum values of axial stress mentioned above are the true values of axial stress, and a compressive stress and a tensile stress are distinguished in the axial direction. For example, on any axis, if the comprehensive axial stress in the intermediate layer is $-5$ MPa to 1 MPa, the maximum value of axial stress is 1 MPa, the minimum value of axial stress is $-5$ MPa, and $\Delta S6$ is 6 MPa. $\Delta S5$, $\Delta S6$, and $\Delta S7$ represent the degree of variation in the axial interplanar spacing of the substrate among the first surface layer, the intermediate layer, and the second surface layer at the microscale. The smaller the values of $\Delta S5$, $\Delta S6$, and $\Delta S7$ are, the smaller the variation in the axial interplanar spacing of the substrate is.

Optionally, 0 MPa $\leq \Delta S5 \leq 14.9$ MPa and 0 MPa $\leq \Delta S7 \leq 14.3$ MPa.

Optionally, the crystal form of the SiC substrate is 2H-SiC, 4H-SiC, 6H-SiC, 3C-SiC, or 15R-SiC.

Optionally, the crystal form of the SiC substrate is 4H-SiC.

Optionally, the SiC substrate is a semi-insulating SiC substrate or a conductive SiC substrate.

Optionally, the bow of the SiC substrate is $-100$ $\mu$m to 100 $\mu$m.

Optionally, the bow of the SiC substrate is $-50$ $\mu$m to 50 $\mu$m.

Optionally, the bow of the SiC substrate is $-11$ $\mu$m to 15 $\mu$m.

Optionally, the deflection angle of the first main surface and/or the second main surface relative to the {0001} plane is less than 4°.

According to another aspect of the present application, an SiC crystal featuring a uniform distribution of stresses in three dimensions is provided; the SiC crystal has a thickness of not less than 0.35 mm and includes an upper surface and a lower surface; in an area between the upper surface and the lower surface, the radial stress at any horizontal plane is $-10$ MPa to 10 MPa.

Optionally, the diameter of the SiC crystal is greater than 150 mm.

Optionally, the diameter of the SiC crystal is greater than 200 mm.

Optionally, based on an axial test by extending downward from any point on the upper surface of the SiC crystal, the axial stress of the SiC crystal is $-10$ MPa to 10 MPa.

Optionally, the axial stress includes an absolute axial stress and a relative axial stress; and

based on an axial test by extending downward from any point on the upper surface of the SiC crystal, the absolute axial stress of the SiC crystal is -10 MPa to 10 MPa, and the relative axial stress of the SiC crystal is -8 MPa to 8 MPa.

Optionally, the relative axial stress of the SiC crystal is -8 MPa to 7.8 MPa.

Optionally, the radial stress includes an absolute radial stress and a relative radial stress; and

in the area from the upper surface to the lower surface, the absolute radial stress of the SiC crystal at any horizontal plane is -10 MPa to 10 MPa, and the relative radial stress of the SiC crystal at any horizontal plane is -8 MPa to 8 MPa.

The absolute and relative stresses mentioned above can present the same characteristics as those that the absolute and relative stresses of the substrate can present.

Optionally, based on an axial test by extending downward from any point on the upper surface of the SiC crystal, S7 represents the maximum axial stress of the SiC crystal and S8 represents the minimum axial stress of the SiC crystal, in which $\triangle S8 = S7 - S8$, and $0\ \text{MPa} \leq \triangle S8 \leq 10\ \text{MPa}$.

The maximum and minimum values of axial stress mentioned above are the true values of axial stress, and a compressive stress and a tensile stress are distinguished in the axial direction. For example, on any axis, if the axial stress of the SiC crystal is -5 MPa to 5 MPa, the maximum value of axial stress is 5 MPa, the minimum value of axial stress is -5 MPa, and $\triangle S8$ is 10 MPa. $\triangle S8$ represents the degree of variation in the axial interplanar spacing of the crystal. The smaller the value of $\triangle S8$ is, the smaller the variation in the axial interplanar spacing of the crystal is.

Optionally, $0\ \text{MPa} \leq \triangle S8 \leq 6.3\ \text{MPa}$.

Optionally, $0\ \text{MPa} \leq \triangle S8 \leq 1.1\ \text{MPa}$.

According to another aspect of the present application, a method for preparing an SiC single crystal is provided, including the following steps:

(1) adding silicon carbide powders to a graphite crucible;

(2) vacuuming the furnace to a pressure lower than $10^{-6}$ mbar, then introducing a high-purity inert gas to a pressure of 300 mbar to 500 mbar, repeating this process 2 to 3 times, and finally vacuuming the furnace to a pressure lower than $10^{-6}$ mbar;

(3) introducing the high-purity inert gas into the furnace to increase the pressure to 10 mbar to 100 mbar in 1 h to 3 h, and continuing to introduce the high-purity inert gas to maintain a constant pressure;

(4) in the crystal growth stage, under the constant pressure, raising the temperature in the furnace to the crystal growth temperature of 2200 K to 2800 K in 3 h to 5 h, and the growth time is 30 h to 150 h; and

(5) after the crystal growth stage is complete, opening the furnace and taking out the graphite crucible to obtain SiC crystals.

Optionally, the graphite crucible is coated with a TaC coating and the TaC coating is deposited on the surface of the graphite substrate. Through holes are evenly distributed in the TaC coating and have a density of 160 to 310 holes per square millimeter. The through holes in the TaC coating can increase the transmission rate of the silicon carbide atmosphere while improving the uniformity of the temperature field during crystal growth, thereby increasing the crystal growth rate and reducing the internal stress of the crystal, to obtain a high-quality and low-stress silicon carbide crystal.

Optionally, the diameter of each of the through holes is 2 $\mu$m to 7 $\mu$m.

Optionally, the diameter of each of the through holes is 2.3 $\mu$m to 6.1 $\mu$m.

This hole diameter can increase the transmission rate of the silicon carbide atmosphere without reducing the protective performance of the graphite substrate, and avoid the generation of edge stress by preventing the crystal from being squeezed by the thermal expansion of the graphite substrate in the thermal field, further reducing the stress in the crystal.

Optionally, the thickness of the TaC coating is 30 $\mu$m to 400 $\mu$m, TaC grains in the TaC coating are arranged in a stacked and staggered manner, and the size range of the TaC grains is 15 $\mu$m to 50 $\mu$m. The TaC grains in the TaC coating grow along the [200] and [220] directions. This growth direction of the TaC grains can improve the temperature resistance and thermal chemical corrosion resistance of the TaC coating, thereby reducing the interference of the graphite substrate on the crystal growth environment and improving the stability of the crystal environment.

The beneficial effects of the present application include but are not limited to:

1. The stress introduced by temperature gradient changes or crystal growth environment changes during SiC crystal growth is the stress in the intermediate layer of the SiC substrate. The stresses in the first surface layer and the second surface layer of the SiC substrate are the stresses generated during the processing of the SiC crystal into the SiC substrate. The stress distribution among the first surface layer, the second surface layer, and the intermediate layer of the SiC substrate according to the present application is uniform, and the stress values are very low, proving that the quality of the SiC substrate is good, which is conducive to the production and processing of downstream products.

2. According to the present application, quantitative stress testing is performed for the SiC substrate, and the surface stress and the internal stress in the SiC substrate are distinguished. This enables the stress distribution of the SiC substrate to be controlled within a reasonable range for different downstream products prepared from the SiC substrate, thereby expanding the use range of the SiC substrate.

3. For the SiC substrate according to the present application, the stresses in the first surface layer, the second surface layer, and the intermediate layer are distributed uniformly in three dimensions, proving that the SiC substrate can be regarded as a body with homogeneous stress distribution, and the surface form of the SiC substrate is also improved.

4. According to the present application, a TaC coating with through holes formed on the surface of the crucible can ensure the transmission of the raw material atmosphere during crystal growth while improving the uniformity of the temperature field, so that the method can be used to prepare low-stress silicon carbide crystals, and the substrate prepared from the crystal can improve the crystal growth quality of epitaxial wafers and subsequent crystals.

5. Based on stress distribution in the different layers of the SiC substrate according to the present application, the parameters of each process of crystal growth and/or substrate processing can be adjusted to prepare a high-quality SiC substrate. The stresses detected with the quantitative testing method according to the present application further include the stress that is generated from the lattice distortion in the substrate but has not been released by defects. Therefore, this method can improve the detection accuracy of stresses of the SiC substrate, and present all the stress information of the entire SiC substrate.

BRIEF DESCRIPTION OF DRAWINGS

To illustrate technical solutions in the embodiments of the present application or in the prior art more clearly, drawings to be used for describing the embodiments or prior art are introduced briefly in the following. Obviously, the drawings in the following description are only some embodiments of the present application, and persons of ordinary skill in the art can derive other drawings from the drawings without creative efforts.

In the drawings:

FIG. 1 is a flow chart of stress testing with Raman spectroscopy involved in Embodiment 1 of the present application.
FIG. 2 is an axial peak intensity distribution diagram of a 4H-SiC substrate involved in Embodiment 2 of the present application.
FIG. 3 shows a schematic diagram of axial stress testing of an SiC substrate with Raman spectroscopy involved in Embodiment 3 of the present application and the corresponding axial stress distribution diagram.
FIG. 4 shows morphological characterization diagrams of a TaC coating in crucible 1# involved in Embodiment 6 of the present application.
FIG. 5 is an XRD test diagram of a TaC coating and TaC in crucible 1# in Embodiment 6 of the present application.

DETAILED DESCRIPTION OF THE EMBODIMENTS

The embodiments of the present application provide an SiC substrate and an SiC crystal that feature a uniform distribution of stresses in three dimensions.

In order to enable those skilled in the art to better understand the technical solutions of the present application, the technical solutions in the embodiments of the present application will be clearly and completely described below with reference to drawings. Obviously, the embodiments described are merely part of the embodiments of the present application, rather than all embodiments. All other embodiments derived by a person of ordinary skill in the art based on the embodiments of the present application without creative efforts shall fall within the scope of protection of the present application.

The principle of substrate stress testing with Raman spectroscopy in the following embodiments is that when a monochromatic laser light of a certain wavelength emitted from the Raman spectrometer passes through a series of optical paths, it is converged by an objective lens onto the substrate surface, where the laser photons interact with the substrate lattice, causing photon scattering. The occurrence of Raman scattering is related to the lattice vibration of the substrate itself. When there is any residual stress in the sample, the tensile or compressive stress will elongate or compress atomic bonds accordingly, resulting in a decrease or increase in the vibration frequency of atoms. This change will be reflected in the Raman spectrum as the characteristic peak of the substrate shifts toward low or high frequency, that is to say, a peak offset occurs.

Embodiment 1: Method for quantitative stress testing of substrate

(1) Calculating the conversion coefficient for conversion of peak offset to stress

First, using a single crystal XRD diffractometer to test a silicon carbide substrate, analyzing the substrate in accordance with reciprocal lattice space mapping, calculating the parameters of a standard 4H-SiC substrate, and comparing the results with the values of standard parameters. Then, according to the Bragg's equation for diffraction, namely $2d\sin\theta = n\lambda$, where d is the interplanar spacing, $\theta$ is the half-angle of diffraction, n is the order of diffraction, and $\lambda$ is the wavelength, testing the $\theta$ and d values of different substrates. It can be seen that the tensile or compressive stress in the crystal will cause expansion or contraction of the interplanar spacing d correspondingly. Based on different interplanar spacings $d_0$ and $d_x$, where $d_x$ further includes $d_1$ and $d_2$, $d_0$ is the theoretical interplanar spacing, $d_1$ is the interplanar spacing in case of tensile stress and is greater than $d_0$, and $d_2$ is the interplanar spacing in case of compressive stress and is less than $d_0$, calculating the interplanar spacing difference $\Delta d$ at different positions, where $\Delta d = d_1 - d_0$ or $\Delta d = d_0 - d_2$.

Comparing the actual peak positions of the substrate obtained by stress testing with Raman spectroscopy with the standard peak positions to calculate the peak offsets $\Delta v$ at different testing points; and based on Hooke's law or the stress-strain formula, calculating the stress values $\sigma$ of the silicon carbide substrate at different testing points, with the ratio of peak offset to stress value at different testing points being the conversion coefficient $\mu$ for conversion of peak offset to stress and the value of $\mu$ ranging from -125 to -2500.

The formula of Hooke's law is $\sigma/S = E \times (\Delta d/d_0)$, where S is the area over which $\sigma$ works and is a fixed value. When Hooke's law is applicable to microscopic calculations, S is the microscopic area, which can be taken as 1; E is the Young's modulus of the substrate, which is a fixed parameter of the substrate; $\Delta d$ is the interplanar spacing difference, which varies with different positions; $d_0$ is the theoretical interplanar spacing; and $\sigma$ is the stress value to be calculated.

The stress-strain formula is $\sigma = E \times \Delta d$, where E is the Young's modulus of the substrate, which is a fixed parameter of the substrate; $\Delta d$ is the interplanar spacing difference, which varies with different positions; and $\sigma$ is the stress value to be calculated.

(2) Method for quantitative stress testing of substrate

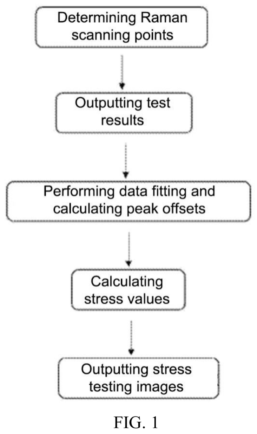

Referring to FIG. 1, first setting the Raman testing points. The testing method can be single-point testing or mapping of the entire substrate. For single-point testing, setting a few scattered coordinate points. For mapping, setting $10\times10$ to $50\times50$ or more points. Selecting an appropriate test method according to the properties of the substrate, and then determining the coordinates of the Raman testing points of the silicon carbide substrate.

Outputting the test results, including but not limited to editable peak positions, peak intensity data, and mapping.

Then, performing peak fitting on the output data with a fitting function, including but not limited to Gaussian, Lorentz, GaussLor, AGauss, Aloren, and AGaussLor, to obtain accurate peak values and peak offsets. The peak positions are accurate to more than 1 decimal place.

Finally, based on the conversion coefficient $\mu$ for conversion of peak offset to stress obtained in (1) and the peak offsets $\Delta v$ obtained in the stress testing with Raman spectroscopy, calculating the stress values of silicon carbide with the formula $\sigma$ (MPa) $= \mu \times \Delta v$ (cm$^{-1}$), and finally outputting the stress testing images of the substrate.

Embodiment 2: Bow testing of substrate surface

Since SiC has undergone a large amount of external mechanical stress in the process of preparing wafers from crystals through a series of processing, it is difficult to ensure that the surface is completely horizontal, that is to say, the substrate surface exhibits a certain degree of bow and warp. In order to eliminate the influence of substrate bow on testing its surface stress and internal stress, it is necessary to first perform bow testing on the substrate. According to the degree of bow, equal-interval focus testing is used for the surface stress of the substrate, and equal-interval focus testing or equal focal plane testing is used for the internal stress of the substrate.

After bow testing, it is necessary to calibrate the tester with single crystal silicon. First, performing Z-axis mapping on a single crystal Si substrate to confirm that its peak intensity is Gaussian distribution. Taking the surface of the single crystal Si substrate as the zero point, and performing axial mapping from a position of -100 $\mu$m in the single crystal Si substrate to another position of +20 $\mu$m above the single crystal Si substrate, to analyze the change of Raman signal intensity and the axial peak intensity distribution diagram of the single crystal Si substrate. The single crystal Si substrate is a non-transparent material, so its peak intensity presents a Gaussian distribution with the zero point at the surface as the symmetry axis. After that, performing single-point focus testing on the surface of the single crystal Si substrate, and using a correction instrument to adjust the position of the Raman signal peak of the single crystal Si substrate to 520.70 cm$^{-1}$. Then, the optical path calibration of the tester is complete.

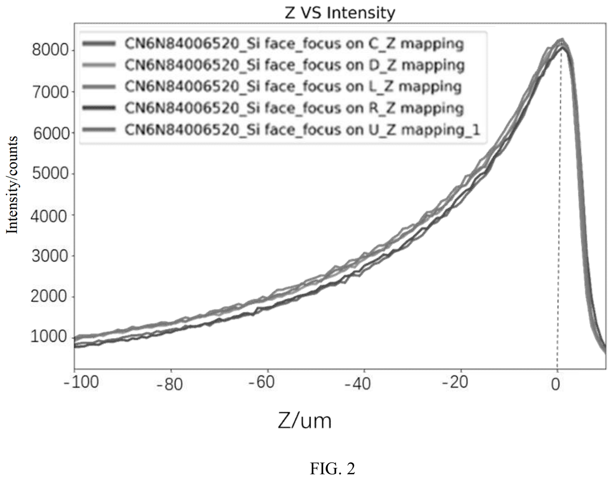

Using the calibrated tester to perform Z-axis testing on the 4H-SiC substrate, in which the testing range of the Raman laser light is from a position of -100 $\mu$m in the 4H-SiC substrate to another position of +20 $\mu$m above the 4H-SiC substrate. FIG. 2 shows an axial peak intensity distribution diagram of the 4H-SiC substrate. The 4H-SiC substrate and other silicon carbides have the characteristics of transparent materials, so the Raman laser light can go into the silicon carbide substrate. As the depth of penetration of the Raman laser light increases, the feedback signal gradually weakens. Other silicon carbide substrates include semi-insulating SiC, conductive SiC, and different crystal forms such as 3C, 4H, 15R, and 6H. Therefore, the Raman peak intensity of the SiC substrate gradually decreases as the depth of penetration of the Raman laser light in the SiC substrate increases.

With its automatic focusing function, the Raman tester can be automatically set to find the strongest peak of the testing signal on the substrate surface, so that the substrate bow can be measured with this function. The specific method is as follows:

S1: First, ensuring the levelness of the test platform, selecting a fixed origin (0, 0) on the test platform, and marking this point with three-dimensional coordinates (0, 0, 0);

S2: Based on the thickness of the substrate, raising an objective lens to a height where the objective lens does not contact the substrate, performing automatic focusing at any point to the position of the strongest testing signal on the substrate surface, marking the position as (a, b, c), and then lowering the Raman laser light by a distance H, to move the position of focus to (a, b, c-H);

S3: Adjusting the testing position of the Raman laser light to (0, 0, c-H) for equal focal plane testing to obtain a two-dimensional peak intensity scanning image of the substrate surface; according to the peak intensity distribution relationship of the silicon carbide substrate in FIG. 2, obtaining the distance between the focal plane of the Raman laser light and the surface of the silicon carbide substrate, thereby obtaining the in-plane bending condition of the substrate and outputting the in-plane bow distribution diagram of the substrate.

Embodiment 3: Axial testing to distinguish between surface stress and internal stress of substrate

Since the substrate is affected by the temperature field and introduction of inclusions during crystal growth, thermal stress and residual stress exist inside the crystal. In addition, the crystal undergoes a series of cutting, grinding, and polishing to obtain the substrate, and this machining process will cause surface lattice distortion, thereby generating surface stress. In order to further distinguish between the surface stress and the internal stress of the substrate, according to the light transmittance characteristics of silicon carbide, axial testing, namely Z-axis mapping, is performed on the substrate. For the axial testing, the substrate surface is taken as the zero point, and the testing range is from a position of -150 $\mu$m to -30 $\mu$m in the substrate to the substrate surface.

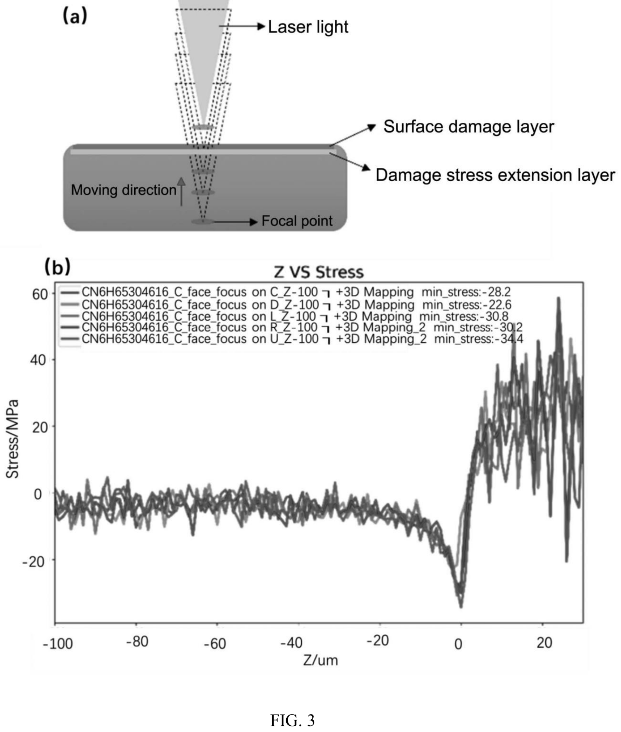

The schematic diagram of this testing is shown in FIG. 3(a), that is to say, the laser light spot is gradually focused upward from the inside of the substrate to the damaged stress extension layer, further to the surface damage layer, and then continues to be focused upward into the air, thereby determining the thicknesses of the surface damage layer and the damaged stress extension layer of the substrate. The substrate surface is taken as the zero point, and the range of axial testing is from a position of -100 $\mu$m in the substrate to another position of 30 $\mu$m above the substrate surface as the Raman laser light spot gradually moves upward. FIG. 3(b) shows a stress axial distribution diagram at 5 points tested on the substrate, namely an upper point, a lower point, a left point, a right point, and a middle point. The 5 points show the same trend, except that the difference lies in the maximum value of negative stress at the surface damage.

As shown in FIG. 3(b), when the laser light spot gradually moves up from a position of -100 $\mu$m to another position of -30 $\mu$m in the substrate, the stress fluctuates along the horizontal line, indicating that the internal stress is uniform. When the laser light spot focuses on the damage stress extension layer, the stress curve begins to show a downward trend at -30 $\mu$m, and the downward trend gradually increases. When the laser light spot approaches the zero point at the substrate surface, the negative stress reaches the maximum value, which is the stress value of the surface damage layer. Finally, the laser light spot continues to move upward and gradually leaves the substrate surface into the air, where the stress rapidly increases and exhibits turbulent fluctuations. Therefore, the thicknesses of the surface damage layer and the damage stress extension layer of the substrate can be determined according to the axial testing results of the substrate, to distinguish the stresses of the substrate into the surface stress and the internal stress, thereby providing a theoretical basis for the subsequent quantitative testing of the surface stress and the internal stress of the substrate.

Embodiment 4: Quantitative testing of internal stress of substrate

During crystal growth by physical vapor transport (PVT), silicon carbide is affected by temperature gradient changes and the introduction of unexpected inclusions, resulting in residual stress in the crystal. Unlike the surface stress due to machining, the internal stress is located at a certain depth from the surface and presents as the thermal stress of crystal growth and the residual stress. In addition, since silicon carbide has undergone a large amount of external mechanical stress in the process of preparing substrates from crystals through a series of processing, it is difficult to ensure that the surface is completely horizontal, that is to say, the substrate surface exhibits a certain degree of bow and warp. According to the method for measuring the substrate bow by stress testing with Raman spectroscopy in Embodiment 2, this embodiment, based on the physical properties of silicon carbide, relates to a method for quantitatively characterizing its internal stress without being affected by substrate bow or warp.

According to the light transmittance characteristics of silicon carbide, Raman laser light is used to quantitatively characterize the internal stress of the substrate, and the method includes equal-interval focus testing and equal focal plane testing, which are described in detail as follows:

1. Equal-interval focus testing

In equal-interval focus testing, as the depth of focus (d) remains unchanged when the Raman laser light focuses on the inside of the substrate at different testing points, first, calculating the depth of penetration (Dp) of the Raman laser light with the following formula:

$$D_p = \frac{1}{\alpha} = \frac{\lambda}{4\pi k}$$

where Dp is the depth of penetration of the excited Raman laser light in the sample, $\alpha$ is the absorption coefficient, $\lambda$ is the wavelength of the laser light, and k is the extinction coefficient. Calculating the specific values of the depth of penetration (Dp) with the above formula, and selecting an appropriate depth of focus (d). It is required that the depth of penetration (Dp) shall be greater than the depth of focus (d); and since the testing target is the internal stress, the depth of focus (d) shall be greater than the thicknesses of the surface damage layer and the damage stress extension layer obtained by testing in Embodiment 3.

Then, calculating the spot diameter (D) of the Raman laser light with the following formula:

$$D = \frac{2\lambda}{N_a{}^2} ,$$

where $\lambda$ is the wavelength of the laser light, and Na is the numerical value of the hole diameter of the device.

The spot diameter (D) is the minor axis diameter of the laser light spot. The larger this value is, the stronger the Raman peak intensity at each testing position is and the more impurity peaks there are, which will affect the detection accuracy of Raman spectroscopy. When $\lambda$ is determined, the larger the Na value is, the weaker the peak intensity is, which will affect the detection accuracy of Raman spectroscopy too. Therefore, it is necessary to select appropriate $\lambda$ and Na values to improve the accuracy of this testing method.

According to the characteristics of silicon carbide, the peak intensity reaches the maximum value when the laser light focuses on the substrate surface, as shown in FIG. 2. Therefore, the automatic focusing function of the Raman tester can realize focusing the laser light on the substrate surface. Then, according to the depth of focus (d) mentioned above, performing equal-interval focus testing at different testing points on the substrate, that is to say, the distance between the focal plane and the substrate surface always remains the same. This method is not affected by bow or warp of the substrate surface, so that the obtained Raman peak intensity is always at the maximum axial value of the testing point. Using the quantitative stress testing method in Embodiment 1 to obtain the internal stress test result diagram of the substrate.

2. Equal focal plane testing

In equal focal plane testing, as the depth of focus (d) changes when the Raman laser light spot focuses on the inside of the substrate at different testing points, and the laser light spot focuses on the same plane in the substrate at different testing points, calculating the depth of penetration (Dp) of the Raman laser light with the same formula as that for equal-interval focus testing, and selecting an appropriate depth of focus (d) with the same method.

Since the focal plane remains the same in this test method, considering the characteristics of silicon carbide, the peak intensity reaches its maximum value when the laser light focuses on the substrate surface and the signal gradually decays as the depth of focus increases. In addition, according to the effective signal-to-noise ratio obtained by the Raman tester, it is found that the effective signal-to-noise ratio is inversely negatively correlated with the depth of focus (d) of the Raman laser light. Therefore, in this testing method, for the depth of focus (d) at different testing points, it is necessary to combine the substrate bow to obtain the effective peak offset by using the quantitative stress testing method in Embodiment 1, thereby reducing the error of internal stress testing.

Through equal-interval focus testing and equal focal plane testing mentioned above, the peak offsets in the substrate can be obtained respectively, and the internal stress distribution of the substrate can be calculated. The difference between the internal stress values of the substrate obtained in equal-interval focus testing and equal focal plane testing is not greater than 0.2 MPa, and the difference between the peak positions obtained in equal-interval focus testing and equal focal plane testing is smaller than 0.0005 cm$^{-1}$. The two methods mentioned above can verify the accuracy of the quantitative testing method according to the present application, and the accuracy of the testing method can be further improved by setting the depth of focus and the spot diameter.

The internal stress includes an absolute internal stress and a relative internal stress. Taking 4H-SiC as an example:

The absolute internal stress is related to the difference between the actual 4H-SiC peak position and the standard peak position in terms of peak position with a fixed reduced wave vector, such as the FTO(2/4) peak position. The calculation formula of the absolute internal stress is:

$$\sigma_{absolute} = \mu \times (V_{actual} - V_{FTO(2/4)}),$$

where $\sigma$ is measured in MPa, $V_{actual}$ and $V_{FTO(2/4)}$ are measured in $cm^{-1}$, $V_{actual}$ is the actual FTO(2/4) peak position at the testing point of the substrate, and $V_{FTO(2/4)}$ is the standard FTO(2/4) peak position of the substrate.

The relative internal stress is related to the difference between the actual peak positions at any two positions in the SiC substrate in terms of peak position with a same reduced wave vector, such as the FTO(2/4) peak position. The calculation formula for the relative internal stress is:

$$\sigma_{relative} = \mu \times (V_{(x1, y1)} - V_{(x2, y2)}),$$

where $\sigma$ is measured in MPa, $V_{(x1, y1)}$ and $V_{(x2, y2)}$ are measured in $cm^{-1}$, $V_{(x1, y1)}$ is the actual FTO(2/4) peak position at the testing point of the substrate, and $V_{(x2, y2)}$ is the actual FTO(2/4) peak position at the relative point of the substrate. Calculating the relative value of the stress at the testing point with the calculation formula above. If the relative value of $\sigma$ is positive, the stress at the testing point relative to the relative point is a tensile stress. If the relative value of $\sigma$ is negative, the stress at the testing point relative to the relative point is a compressive stress.

Embodiment 5: Quantitative testing of surface stress of substrate

Performing axial testing according to Embodiment 3, to determine the thickness of the surface damage layer of the substrate. Since the thickness of the surface damage layer of the substrate is less than the substrate bow, in equal focal plane testing, the laser light spot might fall into the inside of the substrate, resulting in errors in the obtained surface stress of the substrate. Therefore, equal-interval focus testing is mainly used for quantitative testing of surface stress. In this testing method, the depth of focus (d) remains unchanged when the Raman laser light focuses on the surface damage layer of the substrate at different testing points.

First, calculating the depth of penetration (Dp) and spot diameter (D) of the Raman laser light with the same formula as in Embodiment 4, and selecting a suitable depth of focus (d). It is required that the depth of penetration (Dp) shall be greater than the depth of focus (d), and the Raman laser light spot shall be located in the surface damage layer.

According to the depth of focus (d) and spot diameter (D) mentioned above, tuning the parameters of the Raman tester, and using the automatic focusing function to focus the laser light on the substrate surface, so that the surface damage layer of the substrate introduced by processing falls within the range of the laser light spot, thereby realizing equal-interval focus testing at different testing points on the substrate, that is to say, the distance between the focal plane and the substrate surface is always the same. This method is not affected by the substrate bow or warp, so that the obtained Raman peak intensity is always maintained at the maximum value in the axial direction of the testing point. Using the stress quantitative testing method in Embodiment 1 to obtain the stress testing results of the substrate surface.

The methods for quantitatively testing the surface stress and internal stress of the substrate in Embodiments 4 and 5 can eliminate the influence of the substrate bow and warp, thereby enabling quantitative testing of the surface stress and internal stress of the substrate and improving the accuracy of the testing method. Moreover, the method can provide feedback on the adjustment of the process parameters of crystal growth and/or substrate processing, thereby optimizing the process parameters of crystal growth or substrate processing to prepare high-quality substrates.

Embodiment 6

This embodiment relates to a method for preparing a TaC coating with through holes, which includes the following steps:

(1) slurry preparation: mixing 25 to 40 portions of TaC powders, 5 to 8 portions of $Ta_2O_5$, 20 to 35 portions of a solvent, 15 to 25 portions of a cosolvent, 1 to 3 portions of an air entraining agent, 2 to 5 portions of a thickener, 5 to 15 portions of linear saturated aliphatic hydrocarbons, and 1 to 3 portions of carbon powders; and stirring at 700 r/min to 800 r/min for 2 h to 3 h, to obtain a slurry containing TaC; and

(2) spraying the slurry onto a surface with a graphite substrate, raising the temperature to 60°C to 80°C and holding the temperature for 2 h to 4 h to break the bubbles, and then drying at 180°C to 220°C for 8 h to 12 h; sintering at 700 mbar to 900 mbar and 500°C to 700°C for 3 h to 5 h; then raising the pressure to 1000 mbar to 1100 mbar, raising the temperature to 1600°C to 1800°C, and sintering for 8 h to 10 h; then adjusting the pressure to 145 kPa to 155 kPa, raising the temperature to 2200°C to 2400°C, and sintering for 14 h to 16 h; and finally reducing the temperature and pressure to room temperature and normal pressure respectively in 15 h to 25 h to obtain a TaC coating with through holes.

Crucibles 1# to 8# and comparative crucibles D1# to D3# were prepared with the preparation method mentioned above. The details are as follows:

Crucible 1#

(1.1) slurry preparation: mixing 32.7 portions of TaC powders, 6 portions of $Ta_2O_5$, 25 portions of ethanol, 20 portions of tetrahydrofuran, 1.5 portions of a soap-based air entraining agent, 3.5 portions of cellulose ethers, 10 portions of linear saturated aliphatic hydrocarbons, and 1.3 portions of carbon powders; and stirring at 700 r/min for 2.5 h to obtain a slurry containing TaC; and

(1.2) electrostatically spraying the slurry obtained in Step (1.1) onto the surface of a graphite substrate, raising the temperature to 70°C and holding for 3 h to break the bubbles, and then drying at 200°C for 10 h; sintering at 800 mbar and 600°C for 4 h; then raising the pressure to 1000 mbar, raising the temperature to 1700°C, and sintering for 9 h; then adjusting the pressure to 150 kPa, raising the temperature to 2300°C, and sintering for 15 h; and finally reducing the temperature and pressure to room temperature and normal pressure respectively in 20 h to obtain crucible 1#.

Crucible 2#

(2.1) slurry preparation: mixing 25 portions of TaC powders, 5 portions of $Ta_2O_5$, 20 portions of ethanol, 15 portions of tetrahydrofuran, 1 portion of a soap-based air entraining agent, 2 portions of cellulose ethers, 5 portions of linear saturated aliphatic hydrocarbons, and 1 portion of carbon powders; and stirring at 800 r/min for 2 h to obtain a slurry containing TaC; and

(2.2) electrostatically spraying the slurry obtained in Step (2.1) onto the surface of a graphite substrate, raising the temperature to 60°C and holding for 4 h to break the bubbles, and then drying at 180°C for 12 h; sintering at 700 mbar and 500°C for 5 h; then raising the pressure to 1000 mbar, raising the temperature to 1600°C, and sintering for 10 h; then adjusting the pressure to 145 kPa, raising the temperature to 2200°C, and sintering for 16 h; and finally reducing the temperature and pressure to room temperature and normal pressure respectively in 15 h to obtain crucible 2#.

Crucible 3#

(3.1) slurry preparation: mixing 40 portions of TaC powders, 8 portions of $Ta_2O_5$, 35 portions of ethanol, 25 portions of tetrahydrofuran, 3 portions of a soap-based air entraining agent, 5 portions of cellulose ethers, 15 portions of linear saturated aliphatic hydrocarbons, and 3 portions of carbon powders; and stirring at 700 r/min for 3 h to obtain a slurry containing TaC; and

(3.2) electrostatically spraying the slurry obtained in Step (3.1) onto the surface of a graphite substrate, raising the temperature to 80°C and holding for 2 h to break the bubbles, and then drying at 220°C for 8 h; sintering at 900 mbar and 700°C for 3 h; then raising the pressure to 1100 mbar, raising the temperature to 1800°C, and sintering for 8 h; then adjusting the pressure to 155 kPa, raising the temperature to 2400°C, and sintering for 14 h; and finally reducing the temperature and pressure to room temperature and normal pressure respectively in 25 h to obtain crucible 3#.

Crucible 4#

The difference between this embodiment and the embodiment for obtaining crucible 1# lies in that in Step (4.1), after the raw materials were mixed, stirring at 700 r/min for 5 min, with the other conditions being the same as those for obtaining crucible 1#, to obtain TaC coating 4#.

Crucible 5#

The difference between this embodiment and the embodiment for obtaining crucible 1# lies in that in Step (5.2), electrostatically spraying the slurry obtained in Step (5.1) onto the surface of a graphite substrate, raising the temperature to 200°C, and holding for 13 h to break the bubbles before drying and sintering, with the remaining conditions being the same as those for obtaining crucible 1#, to obtain crucible 5#.

Crucible 6#

The difference between this embodiment and the embodiment for obtaining crucible 1# lies in that in Step (6.2), sintering was performed as follows: sintering at 400 mbar and 400°C for 4 h; then raising the pressure to 1000 mbar, raising the temperature to 1700°C, and sintering for 9 h; then adjusting the pressure to 150 kPa, raising the temperature to 2300°C, and sintering for 15 h; and finally reducing the temperature and pressure to room temperature and normal pressure respectively in 20 h, with the remaining conditions being the same as those for obtaining crucible 1#, to obtain crucible 6#.

Crucible 7#

The difference between this embodiment and the embodiment for obtaining crucible 1# lies in that in Step (7.2), sintering was performed as follows: sintering at 800 mbar and 600°C for 4 h; then raising the pressure to 1000 mbar, raising the temperature to 1200°C, and sintering for 9 h; then adjusting the pressure to 150 kPa, raising the temperature to 2300°C, and sintering for 15 h; and finally reducing the temperature and pressure to room temperature and normal pressure respectively in 20 h, with the remaining conditions being the same as those for obtaining crucible 1#, to obtain crucible 7#.

Crucible 8#

The difference between this embodiment and the embodiment for obtaining crucible 1# lies in that in Step (8.2), sintering was performed as follows: sintering at 800 mbar and 600°C for 4 h; then raising the pressure to 1000 mbar, raising the temperature to 1700°C, and sintering for 9 h; then adjusting the pressure to 120 kPa, raising the temperature to 2500°C, and sintering for 15 h, and finally reducing the temperature and pressure to room temperature and normal pressure respectively in 20 h, with the remaining conditions being the same as those for obtaining crucible 1#, to obtain crucible 8#.

Comparative crucible D1#

The difference between this comparative example and the embodiment for obtaining crucible 1# lies in that the TaC coating was prepared with chemical vapor deposition (CVD), specifically:
Putting the graphite substrate into a chemical vapor deposition furnace, vacuuming the furnace to a pressure lower than 50 Pa; then raising the temperature to 1200°C; introducing a mixed gas composed of ethane, $TaCl_5$, $H_2$, and argon as the carrier gas, into the deposition furnace at a constant flow rate, with the furnace pressure maintained at 5000 Pa, in which the molar ratio of $TaCl_5$ and ethane was controlled at 1.2:1 first to form a 50 $\mu$m thick transition layer, and then the molar ratio of $TaCl_5$ and ethane was controlled at 3:1 to forming a 60 $\mu$m thick TaC coating, to obtain comparative crucible D1#.

Comparative crucible D2#

The difference between this comparative example and the embodiment for obtaining crucible 1# lies in that a different raw material of the slurry was used in Step (D2.1). Specifically, a BYK defoamer was used instead of the soap-based air entraining agent, with the other conditions being the same as those for obtaining crucible 1#, to obtain comparative crucible D2#.

Comparative crucible D3#

The difference between this comparative example and the embodiment for obtaining crucible 1# lies in that a different raw material of the slurry was used in Step (D3.1). Specifically, $TaCl_5$ was used instead of $Ta_2O_5$, with the other

conditions being the same as those for obtaining crucible 1#, to obtain comparative crucible D3#.

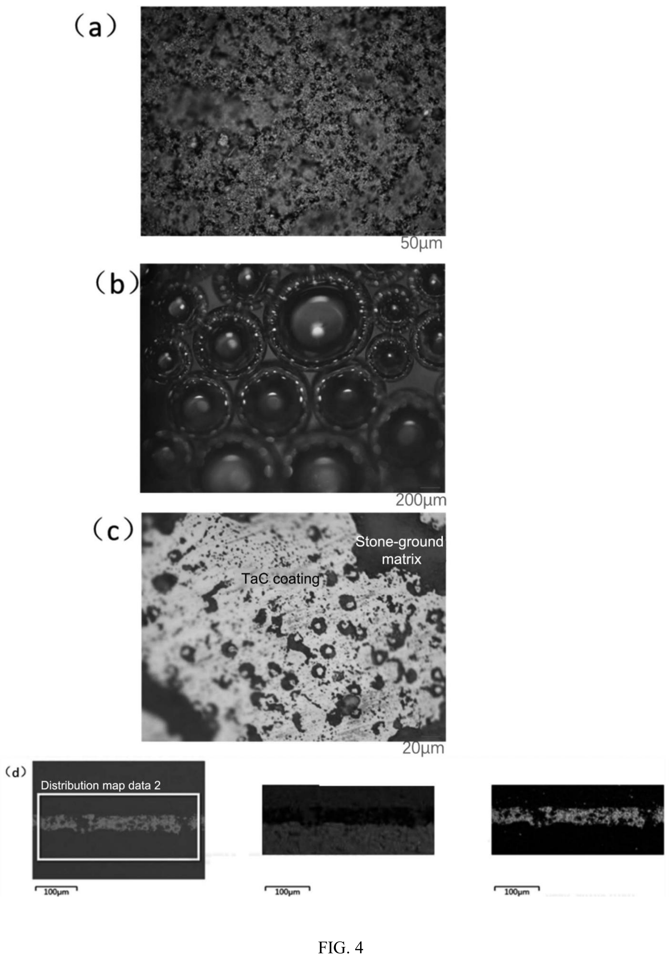

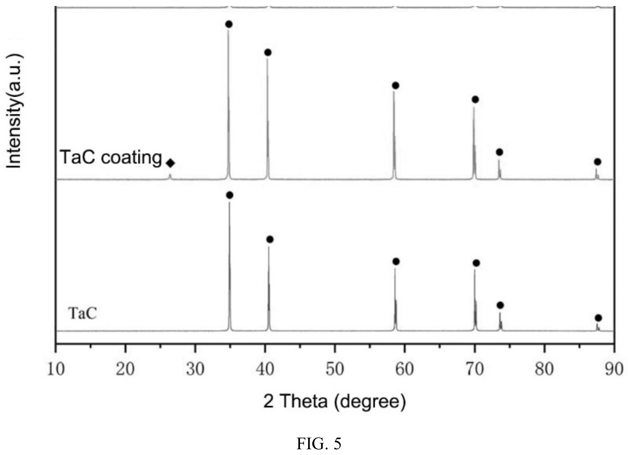

Conducting cross-sectional SEM testing and EDS energy spectrum analysis on crucibles 1# to 8# and comparative crucibles D1# to D3# prepared as mentioned above, and the results are shown in FIG. 4. FIG. 4(a) shows the morphology of a prepared TaC coating with through holes under a microscope, and holes of similar morphology and size are evenly distributed on its surface. FIG. 4(b) shows the morphology of bubbles photographed during the preparation of TaC coating, and apparently, the bubble size is uniform, so that when a TaC coating is prepared with through-hole morphology, its through holes are also evenly distributed. FIG. 4(c) shows the coating after polishing, with the graphite substrate exposed; holes are still visible, proving that the holes formed are through holes. FIG. 4(d) shows SEM and EDS mapping diagrams at the demo section of the coating, which clearly show the distribution of TaC and the penetration of holes, with the EDS diagram proving that this is exactly a Ta-containing coating. FIG. 5 shows that the TaC grains in the TaC coating grow along the [200] and [220] directions. Then testing the thickness of the formed TaC coating, the average diameter and density of the through holes in the TaC coating, and the size of TaC grains. The testing results are shown in Table 1.

Table 1

| Sample | Thickness (μm) | Average diameter of through holes (μm) | Density of through holes | TaC grain size (μm) |
|---|---|---|---|---|
| Crucible 1# | 42 | 4.7 | 310 | 34 |
| Crucible 2# | 31 | 6.1 | 224 | 31 |
| Crucible 3# | 46 | 4.4 | 293 | 33 |
| Crucible 4# | 42 | 2.3 | 160 | 32 |
| Crucible 5# | 41 | 3.6 | 213 | 41 |
| Crucible 6# | 43 | 3.8 | 181 | 43 |
| Crucible 7# | 42 | 4.7 | 267 | 45 |
| Crucible 8# | 41 | 5.9 | 274 | 38 |
| Comparative crucible D1# | 60 | 0 | 0 | 34 |
| Comparative crucible D2# | 43 | 0 | 0 | 31 |
| Comparative crucible D3# | 42 | 5.6 | 247 | 33 |

Conducting high temperature erosion and thermochemical erosion experiments on crucibles 1# to 8# and comparative crucibles D1# to D3# prepared as described above, to simulate the growth environment of the third generation semiconductor SiC crystal by PVT, for which crucibles 1# to 8# and comparative crucibles D1# to D3# were kept at 2300°C in SiC atmosphere for 100 h for erosion experiment. The experiment results are shown in Table 2.

Table 2

| Sample | Weight before experiment (g) | Weight after experiment (g) | Erosion weight loss rate (%) |
|---|---|---|---|
| Crucible 1# | 753 | 702 | 6.8 |
| Crucible 2# | 714 | 639 | 10.5 |
| Crucible 3# | 742 | 701 | 5.5 |
| Crucible 4# | 747 | 714 | 4.4 |
| Crucible 5# | 760 | 721 | 5.1 |
| Crucible 6# | 741 | 708 | 4.5 |
| Crucible 7# | 755 | 716 | 5.2 |
| Crucible 8# | 749 | 698 | 6.8 |
| Comparative crucible D1# | 797 | 769 | 3.5 |
| Comparative crucible D2# | 761 | 707 | 4.1 |

(continued)

| Sample | Weight before experiment (g) | Weight after experiment (g) | Erosion weight loss rate (%) |
|---|---|---|---|
| Comparative crucible D3# | 759 | 704 | 6.5 |

In Table 2, Erosion weight loss rate = [(Weight before experiment - Weight after experiment)/Weight before experiment] $\times$ 100%. The results of high-temperature erosion and thermochemical erosion experiments prove that the TaC coating of this embodiment can improve the protection for the graphite substrate and prolong the tolerance and corrosion resistance of the TaC coating, thereby extending the service life of the crucibles.

Embodiment 7

This embodiment relates to a method for preparing an SiC single crystal, including the following steps:

(1) adding silicon carbide powders to a crucible;
(2) vacuuming the furnace to a pressure lower than $10^{-6}$ mbar, then introducing a high-purity inert gas to a pressure of 300 mbar to 500 mbar, repeating this process 2 to 3 times, and finally vacuuming the furnace to a pressure lower than $10^{-6}$ mbar;
(3) introducing the high-purity inert gas into the furnace to increase the pressure to 10 mbar to 100 mbar in 1 h to 3 h, and continuing to introduce the high-purity inert gas to maintain a constant pressure;
(4) in the crystal growth stage, under the constant pressure, raising the temperature in the furnace to the crystal growth temperature of 2200 K to 2800 K in 3 h to 5 h, and the growth time is 30 h to 150 h; and
(5) after the single crystal growth is complete, opening the furnace and taking out the graphite crucible to obtain SiC single crystals.

Adding equal amounts of silicon carbide powders to crucibles 1# to 3# and comparative crucibles D1# to D3# prepared in Embodiment 6 respectively; vacuuming the furnace to a pressure lower than $10^{-6}$ mbar, then introducing a high-purity inert gas to a pressure of 300 mbar, repeating this process 3 times, and finally vacuuming the furnace to a pressure lower than $10^{-6}$ mbar; introducing the high-purity inert gas into the furnace to increase the pressure to 20 mbar in 1 h, and continuing to introduce the high-purity inert gas to maintain a constant pressure; in the crystal growth stage, under the constant pressure, raising the temperature in the furnace to the crystal growth temperature of 2300 K in 3 h, with the growth time of 80 h; after the single crystal growth is complete, opening the furnace and taking out the graphite crucibles to obtain SiC single crystals 1# to 3# and comparative SiC single crystals D1# to D3# respectively. Then, performing radial and axial stress testing on the SiC single crystals with the testing methods in Embodiment 1 to Embodiment 4. Due to their large thicknesses, the SiC single crystals can be sliced into thinner SiC substrates for internal stress testing, to obtain the difference in axial stress of the SiC single crystals and the difference in radial stress of the SiC single crystals at different axial positions. The testing results are shown in Table 3.

Table 3

| Sample | Radial stress (MPa) | Axial stress (MPa) | $\Delta S8$ (MPa) |
|---|---|---|---|
| SiC single crystal 1# | -3.1~3.6 | -1.3~1.7 | 0~1.1 |
| SiC single crystal 2# | -7.8~8.0 | -8.0~7.5 | 0~6.3 |
| SiC single crystal 3# | -8.0~7.9 | -7.6~7.8 | 0~10.0 |
| Comparative SiC single crystal D1# | -15.0~15.5 | -13.7~14.5 | 0~15.4 |
| Comparative SiC single crystal D2# | -12.6~13.1 | -10.2~12.3 | 0~13.7 |
| Comparative SiC single crystal D3# | -7.4~11.8 | -6.6~10.4 | 0~11.2 |

Embodiment 8

This embodiment relates to the preparation of an SiC substrate, including the following steps:

(1) cutting an SiC single crystal at a cutting speed of 0.005 mm/s to obtain a cut wafer;
(2) grinding the cut wafer with W10 diamond powders at a main disk speed of 75 r/min and a load of 0.3 kg/cm$^2$, to

obtain a ground wafer; and

(3) mechanically polishing the ground wafer with WO.5 diamond powders at a main disk speed of 80 r/min and a load of 0.5 kg/cm$^2$, and then chemically polishing the ground wafer with a chemical mechanical polishing liquid as the polishing material at a main disk speed of 50 r/min, a ceramic disk speed of 35 r/min, and a polishing pressure of 0.15 kg/cm$^2$, to obtain an SiC substrate.

Cutting, grinding, mechanically polishing, and chemical mechanical polishing SiC single crystals 1# to 3# prepared in Embodiment 7 with the steps described above to obtain SiC substrates 1# to 3#. In addition, cutting SiC single crystal 1# at a cutting speed of 0.003 mm/s; grinding the cut wafer with W10 diamond powders at a main plate speed of 69 r/min and at a load of 0.35 kg/cm$^2$; mechanically polishing the ground wafer with WO.5 diamond powders at a main disk speed of 49 r/min and a load of 0.5 kg/cm$^2$ and then chemically polishing the ground wafer with a chemical mechanical polishing liquid as the polishing material at a main disk speed of 50 r/min, a ceramic disk speed of 37 r/min, and a polishing pressure of 0.18 kg/cm$^2$, to obtain SiC substrate 4#. Testing SiC substrates 1# to 4# with the methods in Embodiment 1 to Embodiment 5. The results are shown in Table 4 and Table 5. Table 4 and Table 5 show that the stresses in the first and second surface layers are basically the same, and the stress distribution in the intermediate layer is more uniform.

Table 4

| Sample | Radial stress (MPa) | | | | | | | | |
|---|---|---|---|---|---|---|---|---|---|
| | First surface layer | Second surface layer | Intermed iate layer | $\Delta S1$ | $\Delta S2$ | $Smax_3-Smax_1$ | $\Delta S3$ | $\Delta S4$ | $Smin_3-Smin_1$ |
| SiC substrate 1# | -11.0~ 11.5 | -10.8~10.2 | -3.1~3.6 | -11.2~3.5 | -10.8~3.4 | -2.7~2.5 | -3.5~2.8 | -3.4~2.8 | -1.5~2.2 |
| SiC substrate 2# | -11.2~ 11.8 | -10.9~10.3 | -7.8~8.0 | -10.4~7.2 | -10.7~7.9 | -1.3~3.6 | -4.2~4.1 | -4.2~3.9 | -1.2~2.9 |
| SiC substrate 3# | -11.1~ 11.4 | -10.7~10.2 | -8.0~7.9 | -10.7~7.7 | -10.1~7.5 | -1.4~1.8 | -3.4~5.0 | -3.3~4.8 | -1.2~1 1.6 |
| SiC substrate 4# | -14.9~ 14, 5 | -14.7~14.5 | -3.1~3.6 | -14.9~3.5 | -14.6~3.4 | -4.9~5.0 | -4.8~2.9 | -5.0~2.7 | -4.5~4.4 |

Table 5

| Sample | Axial stress (MPa) | | | | | | Bow (μm) |
|---|---|---|---|---|---|---|---|
| | First surface layer | Second surface layer | Intermediate layer | ΔS5 | ΔS6 | ΔS7 | |
| SiC substrate 1# | -5.2~7.8 | -6.2~4.9 | -1.3~1.7 | 0~9.7 | 0~2.1 | 0~9.6 | 11 |
| SiC substrate 2# | -6.3~5.7 | -5.8~6.1 | -8.0~7.5 | 0~10.8 | 0~7.3 | 0~10.7 | 13 |
| SiC substrate 3# | -6.1~7.0 | -5.7~7.2 | -7.6~7.8 | 0~11.0 | 0~10.0 | 0~11.2 | 12 |
| SiC substrate 4# | -7.8~7.9 | -7.8~8.0 | -1.3~1.7 | 0~14.9 | 0~2.1 | 0~14.3 | 15 |

All the stress values in Table 3 to Table 5 are relative stress values. In the present application, the positive and negative signs before a stress value represent whether the substrate is under a tensile stress or compressive stress. In Table 4, the values of ΔS1 and ΔS2 are the results obtained by numerical calculation using relative stresses. When absolute stresses are used to characterize ΔS1 and ΔS2, the results can meet the requirements of -15 MPa ≤ ΔS1 ≤ 10 MPa and -15 MPa ≤ ΔS2 ≤ 10 MPa. In the prior art, the stress state of a substrate is often described and evaluated by subtracting the minimum value from the maximum value of the above stress values. For example, the axial stress in the first surface layer of SiC substrate 1# is -5.2 to 7.8, so that when the axial stress in the first surface layer of SiC substrate 1# is generally expressed in the art, the values of ΔS1 and ΔS2 can also be described as 13 MPa.

Table 3 to Table 5 above show only the data of the SiC substrates and SiC crystals prepared from crucibles 1# to 3# and comparative crucibles D1# to D3# in Embodiment 6. When the same crystal growth and processing methods as in Embodiments 7 and 8 and crucibles 4# to 8# are used to prepare SiC crystals and SiC substrates, and when the absolute stress is used to characterize the parameters of the crystals and substrates in Table 3 to Table 5, the crystals can meet the requirements that the absolute axial stress shall be -10 MPa to 10 MPa and the relative axial stress shall be -8 MPa to 8 MPa; at any horizontal plane of the crystal, the absolute radial stress shall be -10 MPa to 10 MPa and the relative radial stress shall be -8 MPa to 8 MPa; and 0 MPa ≤ ΔS8 ≤ 10 MPa.

The substrate can meet the following requirements: -15 MPa ≤ ΔS1 ≤ 10 MPa, -15 MPa ≤ ΔS2 ≤ 10 MPa, and -5 MPa ≤ $Smax_3$ - $Smax_1$ ≤ 5 MPa; in the first surface layer of the SiC substrate, the absolute radial stress shall be -15 MPa to 15 MPa, and the relative radial stress shall be -15 MPa to 14.5 MPa; in the second surface layer of the SiC substrate, the absolute radial stress shall be -15 MPa to 15 MPa, and the relative radial stress shall be -15 MPa to 14.5 MPa; in the intermediate layer of SiC substrate, the absolute radial stress shall be -10 MPa to 10 MPa, and the relative radial stress shall be -8 MPa to 8 MPa; -5 MPa ≤ ΔS3 ≤ 5 MPa, -5 MPa ≤ ΔS4 ≤ 5 MPa, and -5 MPa ≤ $Smin_3$ - $Smin_1$ ≤ 5 MPa; the axial stress of the SiC substrate in the first surface layer shall be -10 MPa to 10 MPa, the axial stress of the SiC substrate in the intermediate layer shall be -10 MPa to 10 MPa, and the axial stress of the SiC substrate in the second surface layer shall be -10 MPa to 10 MPa; and 0 MPa ≤ ΔS5 ≤ 15 MPa, 0 MPa ≤ ΔS6 ≤ 10 MPa, and 0 MPa ≤ ΔS7 ≤ 15 MPa.

The embodiments of the present application are described in a progressive manner. The same and similar parts between the embodiments can be referred to each other. Each embodiment focuses on the differences from other embodiments. In particular, for embodiments of devices, equipment, and non-volatile computer storage medium, since they are basically similar to embodiments of a method, the description is relatively simple. Please refer to some descriptions of the method embodiments for relevant content.

Finally, it should be understood that the above embodiments of the present application are only used to illustrate the technical solution of the present disclosure, and are not intended to limit them. Although the present disclosure has been described in detail with reference to the aforementioned embodiments, those of ordinary skill in the art will appreciate that modifications can still be made to the technical solutions described in the aforementioned embodiments, or equivalents may be substituted for certain technical features. Such modifications or substitutions do not make the essence of the corresponding technical solutions depart from the spirit and scope of the technical solutions of the embodiments of the present disclosure.

**Claims**

1. An SiC substrate having a uniform distribution of stresses in three dimensions, wherein the SiC substrate has a thickness of not less than 100 μm and comprises a first main surface and a second main surface, wherein a 10 nm to 30 μm thick area from the first main surface oriented toward the second main surface is a first surface layer, a 10 nm to 30 μm thick area from the second main surface oriented toward the first main surface is a second surface layer, and an area between the first surface layer and the second surface layer is an intermediate layer; and
on a same axis, at any plane parallel to the first main surface or the second main surface, $Smax_1$ represents the

maximum absolute value of a radial stress in the first surface layer, $Smax_2$ represents the maximum absolute value of a radial stress in the intermediate layer, and $Smax_3$ represents the maximum absolute value of a radial stress in the second surface layer, wherein $\Delta S1 = Smax_2 - Smax_1$, $\Delta S2 = Smax_2 - Smax_3$, $-15\,MPa \le \Delta S1 \le 10\,MPa$, and $-15\,MPa \le \Delta S2 \le 10\,MPa$.

2. The SiC substrate according to claim 1, wherein at any plane which is located in the first surface layer and is parallel to the first main surface, the radial stress of the SiC substrate is -15 MPa to 15 MPa;

at any plane which is located in the second surface layer and is parallel to the second main surface, the radial stress of the SiC substrate is -15 MPa to 15 MPa;
at any plane which is located in in the intermediate layer and is parallel to the first main surface or the second main surface, the radial stress of the SiC substrate is -10 MPa to 10 MPa; and
the diameter of the SiC substrate is 150 mm or greater.

3. The SiC substrate according to claim 2, wherein $-5\,MPa \le Smax_3 - Smax_1 \le 5\,MPa$.

4. The SiC substrate according to claim 1, wherein the radial stress comprises an absolute radial stress and a relative radial stress;

at any plane which is located in the first surface layer and is parallel to the first main surface, the absolute radial stress of the SiC substrate is -15 MPa to 15 MPa, and the relative radial stress of the SiC substrate is -15 MPa to 14.5 MPa;
at any plane which is located in the second surface layer and is parallel to the second main surface, the absolute radial stress of the SiC substrate is -15 MPa to 15 MPa, and the relative radial stress of the SiC substrate is -15 MPa to 14.5 MPa; and
at any plane which is located in in the intermediate layer and is parallel to the first main surface or the second main surface, the absolute radial stress of the SiC substrate is -10 MPa to 10 MPa, and the relative radial stress of the SiC substrate is -8 MPa to 8 MPa.

5. The SiC substrate according to claim 1, wherein, on a same axis, at any plane parallel to the first main surface or the second main surface, $Smin_1$ represents the minimum absolute value of radial stress in the first surface layer, $Smin_2$ represents the minimum absolute value of radial stress in the intermediate layer, and $Smin_3$ represents the minimum absolute value of radial stress in the second surface layer, wherein $\Delta S3 = Smin_2 - Smin_1$, $\Delta S4 = Smin_2 - Smin_3$, $-5\,MPa \le \Delta S3 \le 5\,MPa$, and $-5\,MPa \le \Delta S4 \le 5\,MPa$.

6. The SiC substrate according to claim 5, wherein $-5\,MPa \le Smin_3 - Smin_1 \le 5\,MPa$.

7. The SiC substrate according to claim 1, wherein based on an axial test by extending from any point on the first main surface toward the inside of the SiC substrate along the perpendicular direction, the axial stress of the SiC substrate in the first surface layer is -10 MPa to 10 MPa, the axial stress of the SiC substrate in the intermediate layer is -10 MPa to 10 MPa, and the axial stress of the SiC substrate in the second surface layer is -10 MPa to 10 MPa.

8. The SiC substrate according to claim 1, wherein based on an axial test by extending from any point on the first main surface toward the inside of the SiC substrate along the perpendicular direction, S1 represents the maximum axial stress in the first surface layer and S2 represents the minimum axial stress in the first surface layer, wherein $\Delta S5 = S1 - S2$, and $0\,MPa \le \Delta S5 \le 15\,MPa$;

S3 represents the maximum axial stress in the intermediate layer and S4 represents the minimum axial stress in the intermediate layer, wherein $\Delta S6 = S3 - S4$, and $0\,MPa \le \Delta S6 \le 10\,MPa$; and
S5 represents the maximum axial stress in the second surface layer and S6 represents the minimum axial stress in the second surface layer, wherein $\Delta S7 = S5 - S6$, and $0\,MPa \le \Delta S7 \le 15\,MPa$.

9. An SiC crystal having a uniform distribution of stresses in three dimensions, wherein the SiC crystal has a thickness of not less than 0.35 mm and comprises an upper surface and a lower surface; and in an area between the upper surface and the lower surface, the radial stress at any horizontal plane is -10 MPa to 10 MPa.

10. The SiC crystal according to claim 9, wherein the diameter of the SiC crystal is greater than 150 mm.

11. The SiC crystal according to claim 9, wherein based on an axial test by extending downward from any point on the upper surface of the SiC crystal, the axial stress of the SiC crystal is -10 MPa to 10 MPa.

12. The SiC crystal according to claim 11, wherein the axial stress comprises an absolute axial stress and a relative axial stress; and
based on the axial test by extending downward from any point on the upper surface of the SiC crystal, the absolute axial stress of the SiC crystal is -10 MPa to 10 MPa, and the relative axial stress of the SiC crystal is -8 MPa to 8 MPa.

13. The SiC crystal according to claim 9, wherein the radial stress comprises an absolute radial stress and a relative radial stress; and
in the area between the upper surface and the lower surface, the absolute radial stress of the SiC crystal at any horizontal plane is -10 MPa to 10 MPa, and the relative radial stress of the SiC crystal at any horizontal plane is -8 MPa to 8 MPa.

14. The SiC crystal according to claim 9, wherein based on an axial test by extending downward from any point on the upper surface of the SiC crystal, S7 represents the maximum axial stress of the SiC crystal and S8 represents the minimum axial stress of the SiC crystal, wherein $\Delta S8 = S7 - S8$, and $0 \text{ MPa} \leq \Delta S8 \leq 10 \text{ MPa}$.

FIG. 1

FIG. 2

FIG. 3

（a）

50μm

（b）

200μm

（c）

Stone-ground
matrix

TaC coating

20μm

（d）

Distribution map data 2

100μm

100μm

100μm

FIG. 4

FIG. 5

## INTERNATIONAL SEARCH REPORT

| International application No. |
| --- |
| **PCT/CN2024/096122** |

**A. CLASSIFICATION OF SUBJECT MATTER**

C30B23/02(2006.01)i

According to International Patent Classification (IPC) or to both national classification and IPC

**B. FIELDS SEARCHED**

Minimum documentation searched (classification system followed by classification symbols)

IPC: C30B

Documentation searched other than minimum documentation to the extent that such documents are included in the fields searched

Electronic data base consulted during the international search (name of data base and, where practicable, search terms used)

CNTXT; ENTXTC; VEN; CNABS; ENTXT; CNKI; ISI web of science; 万方, WANFANG; 上海天岳半导体材料有限公司, 舒天宇, 石志强, 王旗, 宋猛, 王凯, 张林, 彭红宇, 李林, 徐光明, SiC, 碳化硅, 径向应力, 轴向应力, 体内应力, 体内内应力, 表面应力, 表面加工应力, 兆帕, MPa, silicon carbide, radial stress, axial stress, stress in vivo, surface stress, surface finishing stress

**C. DOCUMENTS CONSIDERED TO BE RELEVANT**

| Category* | Citation of document, with indication, where appropriate, of the relevant passages | Relevant to claim No. |
| --- | --- | --- |
| A | MENG, Dalei et al. "Stress simulation of 6-inch SiC single crystal" *Vacuum*, Vol. 213, 07 April 2023 (2023-04-07), 112081 ISSN: 0042-207X, figure 2 | 1-14 |
| A | CN 114509457 A (SHANDONG UNIVERSITY) 17 May 2022 (2022-05-17) entire document | 1-14 |
| A | CN 113652749 A (SICC CO., LTD.) 16 November 2021 (2021-11-16) entire document | 1-14 |
| A | CN 110129885 A (SICC CO., LTD.) 16 August 2019 (2019-08-16) entire document | 1-14 |
| A | CN 113957533 A (SICC CO., LTD.) 21 January 2022 (2022-01-21) entire document | 1-14 |
| A | CN 115652432 A (SICC CO., LTD.) 31 January 2023 (2023-01-31) entire document | 1-14 |

☐ Further documents are listed in the continuation of Box C.      ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **12 August 2024** | **26 August 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2024/096122**

| Patent document cited in search report | | | Publication date (day/month/year) | Patent family member(s) | | | Publication date (day/month/year) |
|---|---|---|---|---|---|---|---|
| CN | 114509457 | A | 17 May 2022 | None | | | |
| CN | 113652749 | A | 16 November 2021 | CN | 113652749 | B | 12 July 2022 |
| CN | 110129885 | A | 16 August 2019 | CN | 110129885 | B | 19 May 2020 |
| CN | 113957533 | A | 21 January 2022 | CN | 113957533 | B | 27 October 2023 |
| CN | 115652432 | A | 31 January 2023 | None | | | |

Form PCT/ISA/210 (patent family annex) (July 2022)

**REFERENCES CITED IN THE DESCRIPTION**

**Patent documents cited in the description**

- CN 202310746123